# EUROPEAN PATENT APPLICATION

(11) **EP 4 715 413 A1**
(43) Date of publication of application: **25.03.2026**
(21) Application number: 25202703.2
(22) Date of filing: 17.09.2025
(51) Int. Cl.: G01R 33/38, G01R 33/3815

(54) **SUPERCONDUCTING MAGNET AND MAGNETIC RESONANCE IMAGING DEVICE**

(30) Priority: 20.09.2024 CN 202411332245
(71) Applicant: Siemens Healthcare Limited, Camberley, Surrey GU15 3YL (GB)
(72) Inventor: NIE, Yu Xin, Shenzhen, 518128 (CN); HE, Bin, ShenZhen, 518000 (CN); HE, Jianping, Shenzhen, 518152 (CN); GU, Kui Xiang, Shenzhen, 518000 (CN)
(74) Representative: HKW Intellectual Property PartG mbB

(57) **Abstract**

A superconducting magnet, comprising multiple superconducting coils (10) and multiple connection units (20). The multiple superconducting coils (10) are used for forming a main magnetic field for magnetic resonance imaging. The multiple superconducting coils (10) are arranged in an axial direction (A) of the superconducting magnet. Each connection unit (20) is connected to two superconducting coils (10) that are adjacent, and at least one manner of connection to these two superconducting coils (10) is a detachable connection. The connection unit can be connected to a refrigerator (30) of the superconducting magnet, so that cold is transferred to the superconducting coil by means of the connection unit to help reduce maintenance costs of the superconducting magnet, and help reduce temperature differences during cooling of the superconducting magnet. In addition, a magnetic resonance imaging device is also provided.

## Description

### TECHNICAL FIELD

The present invention relates to the field of magnetic resonance imaging, in particular a superconducting magnet and a magnetic resonance imaging device comprising same.

### BACKGROUND ART

During the manufacture of a superconducting magnet, a superconducting coil and a composite material support ring are generally combined into an integral whole by means of resin impregnation, forming the structure of a serially bonded magnet (SBM). When a certain superconducting coil therein is damaged, repair is almost never possible, rather the whole superconducting magnet must be replaced, and maintenance costs are higher. In addition, the temperature of an SBM during cooling is incrementally greater in a circumferential direction, which results in a thermal shrinkage difference between different parts, finally having an unfavourable effect on magnet performance and structural stability. Moreover, in an SBM, magnetic field uniformity cannot be adjusted by means of moving a coil.

### SUMMARY OF THE INVENTION

An object of the present invention is to provide a superconducting magnet, which helps to reduce maintenance costs of superconducting magnets.

Another object of the present invention is to provide a magnetic resonance imaging device, which helps to reduce maintenance costs of superconducting magnets.

The present invention provides a superconducting magnet, which comprises multiple superconducting coils and multiple connection units. The multiple superconducting coils are used for forming a main magnetic field for magnetic resonance imaging. The multiple superconducting coils are arranged in an axial direction of the superconducting magnet. Each connection unit is connected to two superconducting coils that are adjacent, and at least one manner of connection to these two superconducting coils is a detachable connection. The connection unit can be connected to a refrigerator of the superconducting magnet, so that cold is transferred to the superconducting coil by means of the connection unit.

This superconducting magnet helps to reduce maintenance costs of the superconducting magnet. In addition, the refrigerator transfers cold to the superconducting coil by means of the connection unit, which helps to reduce temperature differences during cooling of the superconducting magnet.

In a further schematic embodiment of the superconducting magnet, each connection unit comprises an axial support main body, a connecting body and a connecting fastener. The axial support main body is arranged in the axial direction of the superconducting magnet between two of superconducting coils that are adjacent, to define a minimum distance between the two superconducting coils that are adjacent by means of pressing. The connecting body is fixedly connected to the axial support main body. The connecting fastener passes through one of the connecting body and the superconducting coil in a direction that is perpendicular to the axial direction of the superconducting magnet, and is detachably fixedly connected to the other, to fix the relative positions of the two. This structure has better stability and is convenient to assemble.

In a further schematic embodiment of the superconducting magnet, an axial support main body is in a circular ring shape that extends in a circumferential direction of the superconducting magnet. Each connection unit is provided for each of the superconducting coils detachably connected thereto with a group of the connecting bodies. One group of connecting bodies comprises multiple connecting bodies that are distributed in the circumferential direction of the superconducting magnet. This helps to increase connection strength.

In a further schematic embodiment of the superconducting magnet, an axial end face of the superconducting coil is provided with a slot recessed therein. The connecting body is inserted into the slot in a direction that is parallel to the axial direction of the superconducting magnet. The connecting fastener passes into the superconducting coil from a radial outer side of the superconducting coil and is detachably fixedly connected to the connecting body that is inserted in the slot. This facilitates positioning during mounting.

In a further schematic embodiment of the superconducting magnet, an axial support main body comprises a substrate and a spacer. A connecting body is fixedly connected to the substrate. The spacer is detachably stacked on an axial end face of the substrate. A thickness of the axial support main body in the axial direction of the superconducting magnet is adjustable by means of increasing or decreasing the spacer. A hole of the superconducting coil and the connecting body that is used for each of the connecting fasteners to pass through, but not in a fixed connection, is an elongated hole that extends in the axial direction of the superconducting magnet, or a hole of the superconducting coil and the connecting body that is used for each of the connecting fasteners to pass through, but not in a fixed connection, is multiple holes that are arranged in the axial direction of the superconducting magnet, for adaptation to multiple thicknesses of the axial support main body in the axial direction of the superconducting magnet. This can facilitate adjustment of the distance between adjacent superconducting coils, which can facilitate a uniform field.

In a further schematic embodiment of the superconducting magnet, the connection unit has an annular accommodating cavity that extends in a circumferential direction of the superconducting magnet. The content material of the accommodating cavity can obtain cold from a refrigerator, and can output cold toward the superconducting coil in a direction that is parallel to an axial direction of the superconducting magnet. This helps to further reduce temperature differences during cooling of the superconducting magnet.

In a further schematic embodiment of the superconducting magnet, the content material is a solid heat conducting filler or a flowing refrigerant. In a scenario in which the content material is a solid heat conducting filler, the superconducting magnet further comprises copper braid. The refrigerator transfers cold to the content material by means of the copper braid. In a scenario in which the content material is a flowing refrigerant, the superconducting magnet further comprises a connecting tube. One end of the connecting tube communicates with an accommodating cavity. The refrigerator is connected to the other end of the connecting tube, to cool flowing refrigerant that reaches the other end of the connecting tube. This helps to increase the flexibility of the spatial arrangement.

In a further schematic embodiment of the superconducting magnet, each connection unit comprises an auxiliary heat conducting plate. The auxiliary heat conducting plate is in the shape of a tube that extends along an axial direction of the superconducting magnet and forms an outer peripheral cavity wall or an inner peripheral cavity wall of an accommodating cavity. The auxiliary heat conducting plate is attached to a circumferential face of a superconducting coil in a thermally conductive manner, to transfer cold to the superconducting coil. This helps to increase a cooling speed of the superconducting magnet.

In a further schematic embodiment of the superconducting magnet, a connection unit is provided with a reinforcement structure in an accommodating cavity. The reinforcement structure is supported in an axial direction of the superconducting magnet between two side cavity walls of the accommodating cavity in the axial direction of the superconducting magnet. The reinforcement structure helps to improve pressure resistance of the connection unit in the axial direction.

In a further schematic embodiment of the superconducting magnet, the superconducting coil comprises a conductive wire, a connection block and an embedded body. The conductive wire is used for forming a main magnetic field for magnetic resonance imaging. The connection block is arranged at an axial extremity of the superconducting coil and is connected to the connection unit. The conductive wire and the connection block are fixed to the embedded body in an embedding manner. This helps to improve the stability of the overall structure of the superconducting coil.

The present invention provides a magnetic resonance imaging device, comprising the superconducting magnet described above. The superconducting magnet is used for forming a main magnetic field for magnetic resonance imaging. This helps to reduce maintenance costs of the superconducting magnet. In addition, the refrigerator transfers cold to the superconducting coil by means of the connection unit, which helps to reduce temperature differences during cooling of the superconducting magnet.

### BRIEF DESCRIPTION OF THE DRAWINGS

The accompanying drawings below merely illustrate and explain the present invention schematically, without limiting the scope thereof.
Fig. 1 is a three-dimensional drawing intended to illustrate a first schematic embodiment of a superconducting magnet.
Fig. 2 is an exploded view of the superconducting magnet shown in Fig. 1.
Fig. 3 is a sectional view of the superconducting magnet shown in Fig. 1.
Fig. 4 is an exploded view of a partial structure of the superconducting magnet shown in Fig. 1.
Fig. 5 is intended to illustrate a second schematic embodiment of a superconducting magnet.
Fig. 6 is intended to illustrate the specific structure of a superconducting coil of the superconducting magnet shown in Fig. 1.
Fig. 7 is intended to illustrate a third schematic embodiment of a superconducting magnet.
Fig. 8 is intended to illustrate a fourth schematic embodiment of a superconducting magnet.
Fig. 9 is intended to illustrate a fifth schematic embodiment of a superconducting magnet.
Fig. 10 is intended to illustrate a sixth schematic embodiment of a superconducting magnet.
Fig. 11 is a three-dimensional drawing intended to illustrate the sixth schematic embodiment of a superconducting magnet.
Fig. 12 is intended to illustrate a seventh schematic embodiment of a superconducting magnet.

### KEY TO LABELS

- 10: superconducting coil
- 11: slot
- 12: conductive wire
- 13: connection block
- 14: embedded body
- 15: hole
- 20: connection unit
- 21: axial support main body
- 211: substrate
- 212: spacer
- 23: accommodating cavity
- 24: connecting body
- 25: connecting fastener
- 26: auxiliary heat conducting plate
- 27: reinforcement structure
- 30: refrigerator
- 40: content material
- 50: copper braid
- 60: connecting tube
- A: axial direction of superconducting magnet
- C: circumferential direction of superconducting magnet

### DETAILED DESCRIPTION OF EMBODIMENTS

To enable clearer understanding of the technical features, objectives and effects of the invention, particular embodiments of the present invention are now explained with reference to the accompanying drawings, in which identical labels indicate structurally identical components or components with similar structures but identical functions.

As used herein, "schematic" means "serving as an instance, example or illustration". No drawing or embodiment described herein as "schematic" should be interpreted as a more preferred or more advantageous technical solution.

As used herein, "first" and "second", etc. do not indicate order or degree of importance, etc., merely being used to indicate a distinction between parts, to facilitate description herein.

As used herein, "multiple" means greater than or equal to two.

To make the drawings appear uncluttered, only those parts relevant to the present invention are shown schematically in the drawings; they do not represent the actual structure thereof as a product.

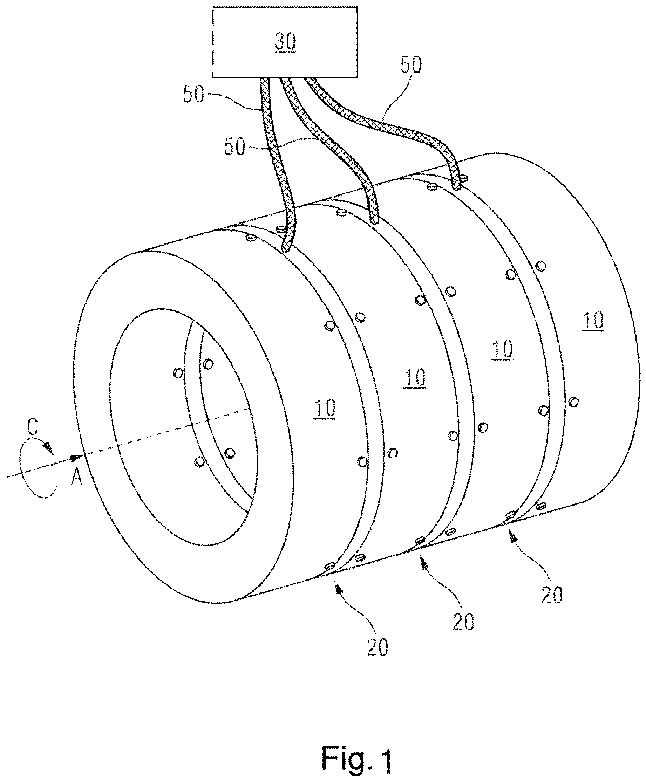

Fig. 1 is a three-dimensional drawing intended to illustrate a first schematic embodiment of a superconducting magnet. As shown in Fig. 1, the superconducting magnet comprises four superconducting coils 10 and three connection units 20. The superconducting coils 10 are used for forming a main magnetic field for magnetic resonance imaging. The superconducting coil 10 is a ring-shaped structure that surrounds a circumferential direction C of the superconducting magnet. The four superconducting coils 10 are arranged in an axial direction A of the superconducting magnet. Each connection unit 20 is detachably connected to two superconducting coils 10 that are adjacent, to fix the relative positions of these two superconducting coils 10. The connection unit 20, for example, is an annular structure that surrounds the circumferential direction C of the superconducting magnet. The connection unit 20 can be connected to a refrigerator 30 of the superconducting magnet, so that cold is transferred to the superconducting coil 10 by means of the connection unit 20. The refrigerator 30, for example, is connected to the connection unit 20 by means of copper braid 50, but is not limited to this.

Since the superconducting coils 10 and the connection units 20 are detachably connected to each other, when one of the superconducting coils 10 is damaged, the damaged coil can be removed and replaced with a new superconducting coil 10. This helps to reduce maintenance costs of the superconducting magnet.

But there is not a limitation to this; in other schematic embodiments, each connection unit 20 may also be connected to two superconducting coils 10 that are adjacent, and the manner of connection to one of these two superconducting coils 10 is a detachable connection, and the manner of connection to the other of the two superconducting coils 10 is a non-detachable permanent connection. We take the combined body of the superconducting coil 10 and the connection unit 20 that is permanently connected thereto as one replacement unit. In this scenario, when one of the superconducting coils 10 is damaged, the replacement unit where the damaged coil is located may be removed and replaced with a new replacement unit. This likewise helps to reduce maintenance costs of the superconducting magnet. In addition, the refrigerator 30 transfers cold to the superconducting coil 10 by means of the connection unit 20, which helps to reduce temperature differences during cooling of the superconducting magnet.

In other schematic embodiments, the number of superconducting coils 10 of the superconducting magnet may be adjusted as required. The number of connection units 20 is correspondingly adjusted according to the number of superconducting coils 10.

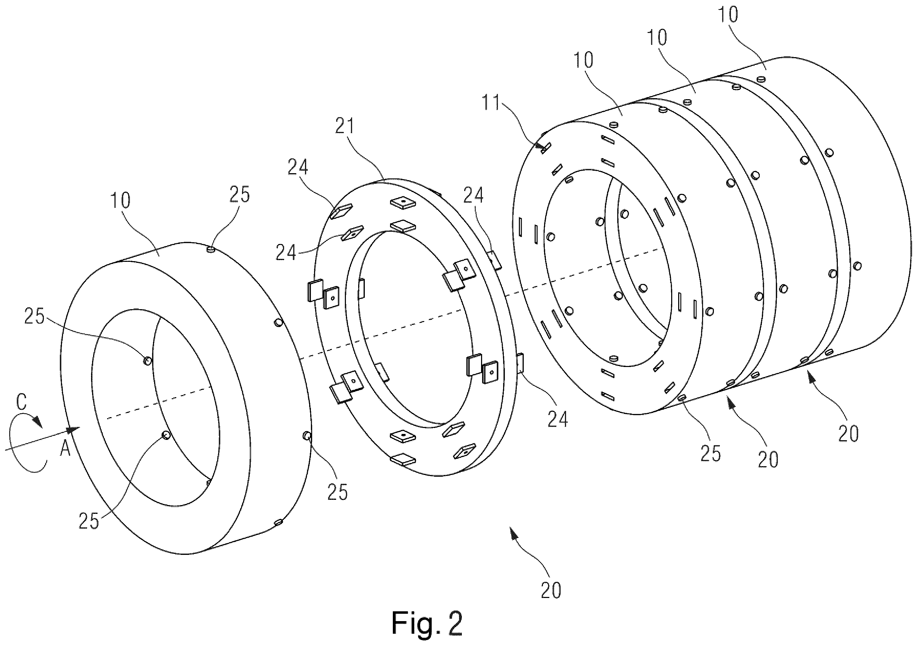

Fig. 2 is an exploded view of the superconducting magnet shown in Fig. 1. Specifically, as shown in Fig. 2, in the present schematic embodiment, each connection unit 20 comprises an axial support main body 21, two groups of connecting bodies 24 (each group having 16, and the two groups of connecting bodies 24 being respectively located on two sides of the axial support main body 21 in the axial direction A) and two groups of connecting fasteners 25 (each group having 16, and the two groups of connecting fasteners 25 respectively corresponding to the two groups of connecting bodies 24, the connecting fasteners 25 in Fig. 2 not being removed from the superconducting coil 10). One group of connecting bodies 24 and one group of connecting fasteners 25 in each group of connection units 20 are used for connecting one superconducting coil 10.

The axial support main body 21 is arranged in the axial direction A of the superconducting magnet between two of the superconducting coils 10 that are adjacent, to define a minimum distance between the two of superconducting coils 10 that are adjacent by means of pressing; that is, the axial support main body 21 is clamped between two adjacent superconducting coils 10, thereby defining the minimum distance between the two adjacent superconducting coils 10. The axial support main body 21, for example, is a circular ring structure that surrounds the circumferential direction C of the superconducting magnet. During use of the superconducting magnet, the four superconducting coils 10 attract each other in the axial direction A, generating a squeezing force on the axial support main body 21 in the axial direction A.

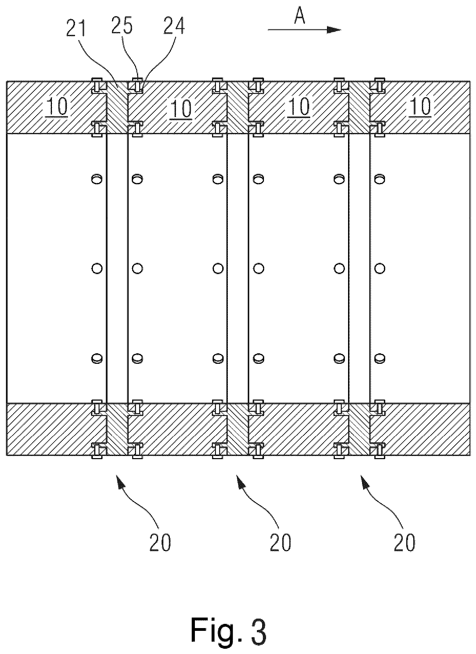

As shown in Fig. 2, the connecting body 24 is fixedly connected to the axial support main body 21. Fig. 3 is a sectional view of the superconducting magnet shown in Fig. 1. As shown in Fig. 3, the connecting body 24 overlaps the superconducting coil 10 in a direction that is perpendicular to the axial direction A of the superconducting magnet. For each connecting body 24, a connecting fastener 25 passes through one of the connecting body 24 and the superconducting coil 10 in a direction that is perpendicular to the axial direction A of the superconducting magnet, and is detachably fixedly connected to the other, to fix the relative positions of the two.

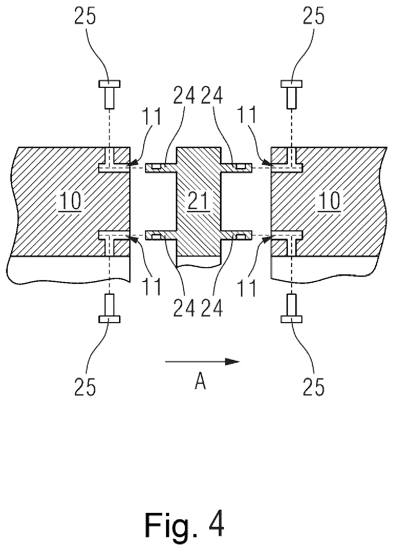

Specifically, in the present schematic embodiment, for each connecting body 24, an axial end face of the superconducting coil 10 is provided with a slot 11 recessed therein (see Fig. 2). The connecting body 24 is inserted into the slot 11 in a direction that is parallel to the axial direction A of the superconducting magnet. The connecting fastener 25 passes into the superconducting coil 10 from a radial outer side of the superconducting coil 10 and is detachably fixedly connected to the connecting body 24 that is inserted in the slot 11. Fig. 4 is an exploded view of a partial structure of the superconducting magnet shown in Fig. 1. Referring to Fig. 4, during mounting, the connecting body 24 is first inserted into the slot 11 in the direction that is parallel to the axial direction A, and then the connecting fastener 25 is fitted in, fixing the superconducting coil 10 to the connecting body 24.

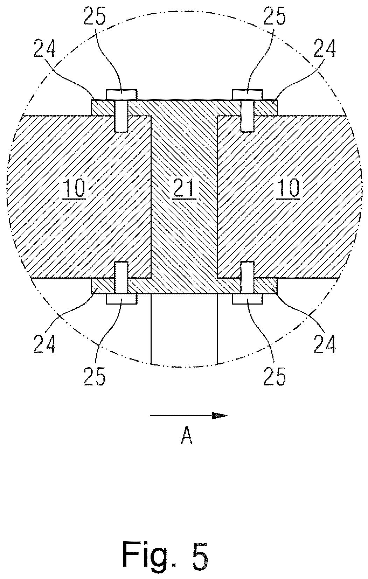

In another schematic embodiment, as shown in Fig. 5, a connecting body 24 also may overlap a radial inner side or a radial outer side of a superconducting coil 10. In such a scenario, a connecting fastener 25 passes through the connecting body 24 and is then detachably fixedly connected to the superconducting coil 10. Compared to the schematic embodiment shown in Fig. 5, the schematic embodiment shown in Figs. 1 to 4 better facilitates positioning during mounting.

In the present schematic embodiment, the connecting fastener 25 is a screw, for example, but is not limited to this; in other schematic embodiments, the connecting fastener 25 may also be a pin, etc.

As shown in Fig. 2, in the present schematic embodiment, a group of connecting bodies 24 of each connection unit 20 that are used for connecting a superconducting coil 10 comprises many pairs of connecting bodies 24 that are distributed evenly in a circumferential direction C of the superconducting magnet. This helps to increase connection strength. Two connecting bodies 24 in each pair of connecting bodies 24 are distributed in a radial direction of the superconducting magnet, one being near a radial inner side to facilitate mounting the connecting fastener 25 from an inner side, and the other being near a radial outer side to facilitate mounting the connecting fastener 25 from an outer side. In schematic embodiments, the number and arrangement of connecting bodies 24 in the groups of connecting bodies 24 may be adjusted as required.

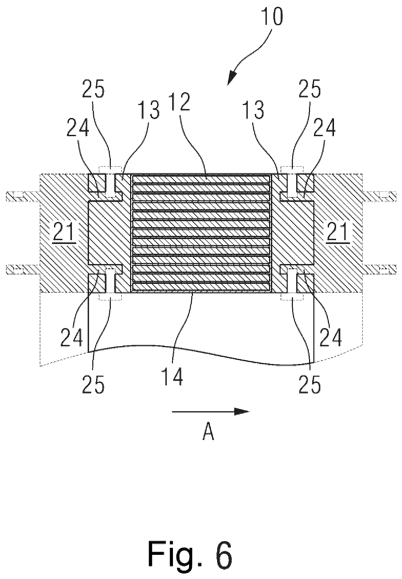

Fig. 6 is intended to illustrate the specific structure of a superconducting coil of the superconducting magnet shown in Fig. 1. As shown in Fig. 6, in a schematic embodiment, the superconducting coil 10 comprises a conductive wire 12, a connection block 13 and an embedded body 14. The conductive wire 12 is used for forming a main magnetic field for magnetic resonance imaging. The connection block 13 is arranged at an axial extremity of the superconducting coil 10, and the conductive wire 12 and the connection block 13 are fixed to the embedded body 14 in an embedding manner. Each connection block 13 is detachably connected to a connection unit 20. Specifically, a slot 11 is arranged on the connection block 13, and a connecting fastener 25 passes into the connection block 13 from a radial outer side of the superconducting coil 10 and is detachably fixedly connected to a connecting body 24 that is inserted in the slot 11. This helps to improve the stability of the overall structure. In the present schematic embodiment, of the four superconducting coils 10, superconducting coils 10 that are located at two ends only have one connection block 13, and two ends of the superconducting coils 10 that are located at middle positions each have one connection block 13. The material of the connection block 13, for example, is a material with a higher mechanical strength such as a glass fiber composite material. The material of the embedded body 14, for example, is an epoxy resin, with a thickness that may be set as required; for example, to reduce the weight and volume of the superconducting coil, the embedded body 14 is configured to be as thin as possible on the basis that strength is ensured.

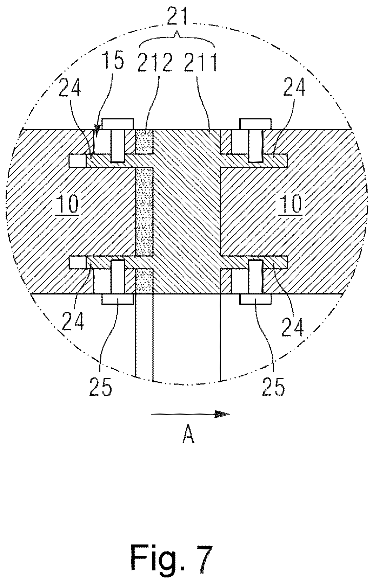

Fig. 7 is intended to illustrate a third schematic embodiment of a superconducting magnet. Features of the superconducting magnet of the present schematic embodiment which are identical or similar to those of the superconducting magnet shown in Figs. 1 to 4 will not be described again here; features which differ are as follows.

As shown in Fig. 7, in the present schematic embodiment, an axial support main body 21 comprises a substrate 211 and a spacer 212. A connecting body 24 is fixedly connected to the substrate 211. The spacer 212 is detachably stacked on an axial end face of the substrate 211, and a thickness of the axial support main body 21 in the axial direction A of the superconducting magnet is adjustable by means of increasing or decreasing the spacer 212. The spacer 212, for example, is an annular plate shape that extends in a circumferential direction C of the superconducting magnet. In Fig. 7, a spacer 212 is only stacked on a left side of the substrate 211; during use, a spacer 212 may be stacked on both sides of the substrate 211 as required, and the number of spacers 212 stacked on each side and the thickness of the spacer 212 may both be adjusted as required, so that the thickness of the axial support main body 21 in the axial direction A of the superconducting magnet is flexibly adjusted. This can facilitate adjustment of the distance between adjacent superconducting coils 10, which can facilitate a uniform field.

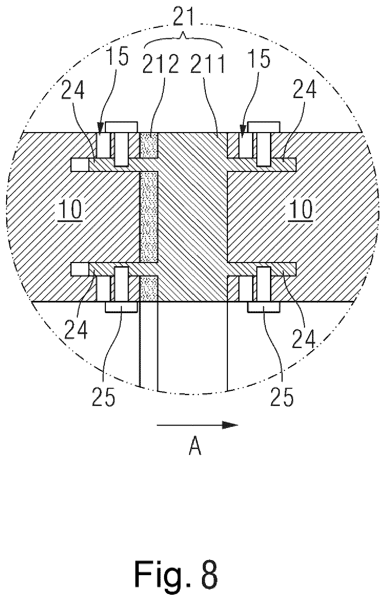

To cooperate with such adjustment, as shown in Fig. 7, in the present schematic embodiment, a hole 15 of the superconducting coil 10 that is used for each connecting fastener 25 to pass through is an elongated hole that extends in the axial direction A of the superconducting magnet, but there is not a limitation to this. In another schematic embodiment, as shown in Fig. 8, a hole 15 of the superconducting coil 10 that is used for each of the connecting fasteners 25 to pass through, for example, is multiple holes that are arranged in the axial direction A of the superconducting magnet (two are used in the figure as an example for schematic illustration, wherein one is occupied by a connecting fastener 25 and one is vacant). This is adapted to multiple thicknesses of the axial support main body 21 in the axial direction A of the superconducting magnet.

The material of the substrate 211 and the connecting body 24, for example, is a material with a higher mechanical strength such as stainless steel. A combined body of the substrate 211 and the connecting body 24, for example, is made in a one-step molding process to increase connection strength. The material of the spacer 212, for example, is a material with a higher mechanical strength such as stainless steel or plastic.

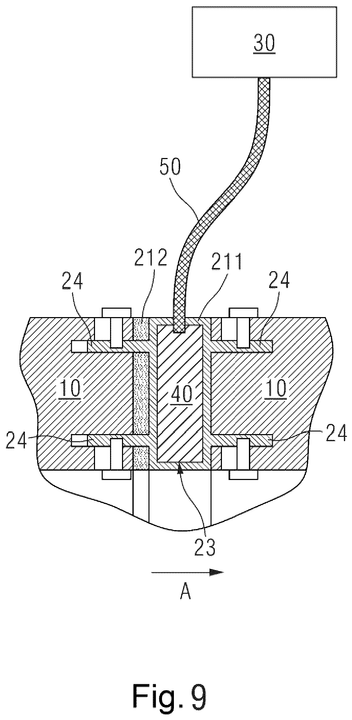

Fig. 9 is intended to illustrate a fifth schematic embodiment of a superconducting magnet. Features of the superconducting magnet of the present schematic embodiment which are identical or similar to those of the superconducting magnet shown in Fig. 7 will not be described again here; features which differ are as follows.

As shown in Fig. 9, in the present schematic embodiment, a substrate 211 has an annular accommodating cavity 23 that extends in a circumferential direction C of the superconducting magnet. Content material 40 is filled in the accommodating cavity 23, the content material 40 being a solid heat conducting filler, which for example is a material with higher thermal conductivity such as high-purity aluminum. The content material 40 of the accommodating cavity 23 can obtain cold from a refrigerator 30, and can output cold toward the superconducting coil 10 in a direction that is parallel to an axial direction A of the superconducting magnet. This helps to further reduce temperature differences during cooling of the superconducting magnet. Specifically, as shown in Fig. 9, the superconducting magnet, for example, further comprises copper braid 50. The refrigerator 30 transfers cold to the content material 40 by means of the copper braid 50, which helps to increase flexibility of the spatial arrangement.

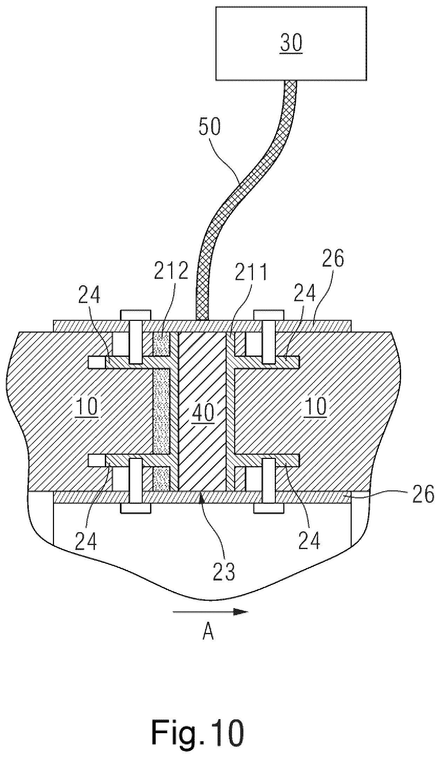

Fig. 10 is intended to illustrate a sixth schematic embodiment of a superconducting magnet. Features of the superconducting magnet of the present schematic embodiment which are identical or similar to those of the superconducting magnet shown in Fig. 9 will not be described again here; features which differ are as follows.

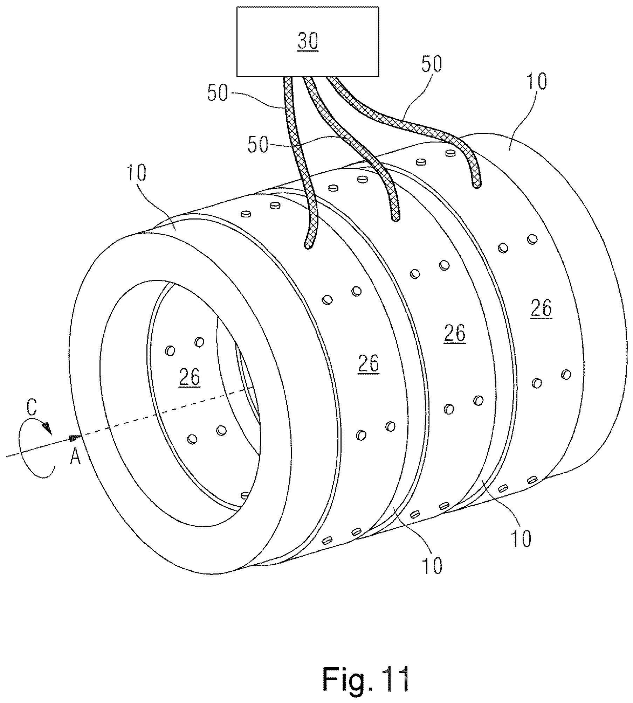

As shown in Fig. 10, in the present schematic embodiment, each connection unit 20 comprises two auxiliary heat conducting plates 26. The two auxiliary heat conducting plates 26 are both in the shape of a tube that extends along an axial direction A of the superconducting magnet and respectively form an outer peripheral cavity wall and an inner peripheral cavity wall of an accommodating cavity 23; that is, the accommodating cavity 23 is jointly defined by a substrate 211 and two auxiliary heat conducting plates 26. The two auxiliary heat conducting plates 26 are respectively attached to a circumferential outer surface and a circumferential inner surface of a superconducting coil 10 in a thermally conductive manner, to transfer cold to the superconducting coil 10, which helps to increase a cooling speed of the superconducting magnet. The material of the auxiliary heat conducting plate 26, for example, is a material with higher thermal conductivity such as high-purity aluminum. The auxiliary heat conducting plate 26 and the substrate 211, for example, are connected in a sealed manner by welding. Fig. 11 shows a three-dimensional drawing of this superconducting magnet. However, there is not a limitation to this; in another schematic embodiment, each connection unit 20 may also only be provided with one auxiliary heat conducting plate 26, and this one auxiliary heat conducting plate 26 forms an outer peripheral cavity wall or an inner peripheral cavity wall of the accommodating cavity 23.

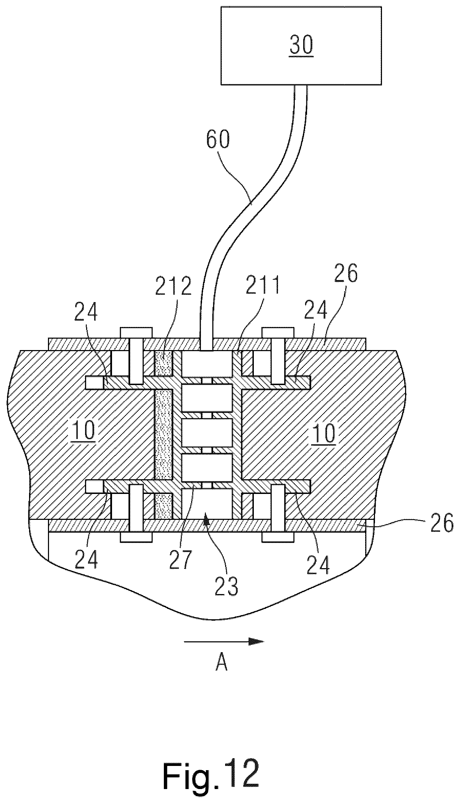

Fig. 12 is intended to illustrate a seventh schematic embodiment of a superconducting magnet. Features of the superconducting magnet of the present schematic embodiment which are identical or similar to those of the superconducting magnet shown in Fig. 10 will not be described again here; features which differ are as follows.

As shown in Fig. 12, in the present schematic embodiment, the accommodating cavity 23, for example, is used for being filled with a flowing refrigerant such as helium. The superconducting magnet further comprises a connecting tube 60. One end of the connecting tube 60 communicates with the accommodating cavity 23. A refrigerator 30 is connected to the other end of the connecting tube 60, to cool flowing refrigerant that reaches the other end of the connecting tube 60.

As shown in Fig. 12, in a schematic embodiment, a connection unit 20 is provided with a reinforcement structure 27 in an accommodating cavity 23. The reinforcement structure 27 is supported in an axial direction A of the superconducting magnet between two side cavity walls of the accommodating cavity 23 in the axial direction A of the superconducting magnet. Specifically, the reinforcement structure 27, for example, is in a plate shape that extends in the axial direction A of the superconducting magnet, and is provided thereon with a hole that allows flowing refrigerant to pass through. During use of the superconducting magnet, the four superconducting coils 10 attract each other in the axial direction A, generating a squeezing force on the substrate 211 in the axial direction A. The reinforcement structure 27 helps to improve pressure resistance of the connection unit 20 in the axial direction A.

The present invention provides a magnetic resonance imaging device, comprising the superconducting magnet described above. The superconducting magnet is used for forming a main magnetic field for magnetic resonance imaging. This helps to reduce maintenance costs of the superconducting magnet. In addition, the refrigerator 30 transfers cold to the superconducting coil 10 by means of the connection unit 20, which helps to reduce temperature differences during cooling of the superconducting magnet. Specifically, in a scenario in which the superconducting magnet is the superconducting magnet corresponding to Figs. 7 to 12, a distance between adjacent superconducting coils 10 can be conveniently adjusted to achieve a uniform field. In a scenario in which the superconducting magnet is the superconducting magnet corresponding to Figs. 9 to 12, a further reduction of temperature differences during cooling of the superconducting magnet is facilitated, and thermal shrinkage differences between parts are reduced, improving product performance and stability.

It should be understood that although the description herein is based on various embodiments, it is by no means the case that each embodiment contains only one independent technical solution. Such a method of presentation is adopted herein purely for the sake of clarity. Those skilled in the art should consider the description in its entirety. The technical solutions in the various embodiments could also be suitably combined to form other embodiments understandable to those skilled in the art.

The series of detailed explanations set out above are merely particular explanations of feasible embodiments of the present invention, and are not intended to limit the scope of protection thereof. All equivalent embodiments or changes made without departing from the artistic spirit of the present invention, such as combinations, divisions or repetitions of features, shall be included in the scope of protection of the present invention.

## Claims

1. A superconducting magnet, comprising:
multiple superconducting coils (10), which are used for forming a main magnetic field for magnetic resonance imaging, the multiple superconducting coils (10) being arranged in an axial direction (A) of the superconducting magnet; and
multiple connection units (20), each of the connection units (20) being connected to two of the superconducting coils (10) that are adjacent, and at least one manner of connection to these two superconducting coils (10) being a detachable connection;
the connection unit (20) can be connected to a refrigerator (30) of the superconducting magnet, so that cold is transferred to the superconducting coil (10) by means of the connection unit (20).

2. The superconducting magnet as claimed in claim 1, wherein each of the connection units (20) comprises:
an axial support main body (21), which is arranged in the axial direction (A) of the superconducting magnet between two of the superconducting coils (10) that are adjacent, to define a minimum distance between two of the superconducting coils (10) that are adjacent by means of pressing;
a connecting body (24), which is fixedly connected to the axial support main body (21); and
a connecting fastener (25), which passes through one of the connecting body (24) and the superconducting coil (10) in a direction that is perpendicular to the axial direction (A) of the superconducting magnet, and is detachably fixedly connected to the other, to fix the relative positions of the two.

3. The superconducting magnet as claimed in claim 2, wherein the axial support main body (21) is in the shape of a circular ring that extends in a circumferential direction (C) of the superconducting magnet, each of the connection units (20) being provided for each of the superconducting coils (10) detachably connected thereto with a group of the connecting bodies (24), and the group of connecting bodies (24) comprising multiple connecting bodies (24) that are distributed evenly in the circumferential direction (C) of the superconducting magnet.

4. The superconducting magnet as claimed in claim 2, wherein an axial end face of the superconducting coil (10) is provided with a slot (11) recessed therein, the connecting body (24) being inserted in the slot (11) in a direction that is parallel to the axial direction (A) of the superconducting magnet, and the connecting fastener (25) passing into the superconducting coil (10) from a radial outer side of the superconducting coil (10) and being detachably fixedly connected to the connecting body (24) that is inserted in the slot (11).

5. The superconducting magnet as claimed in claim 2, wherein the axial support main body (21) comprises:
a substrate (211), the connecting body (24) being fixedly connected to the substrate (211); and
a spacer (212), which is detachably stacked on an axial end face of the substrate (211), a thickness of the axial support main body (21) in the axial direction (A) of the superconducting magnet being adjustable by means of increasing or decreasing the spacer (212);
a hole of the superconducting coil (10) and the connecting body (24) that is used for each of the connecting fasteners (25) to pass through, but not in a fixed connection, is an elongated hole that extends in the axial direction (A) of the superconducting magnet, or a hole of the superconducting coil (10) and the connecting body (24) that is used for each of the connecting fasteners (25) to pass through, but not in a fixed connection, is multiple holes that are arranged in the axial direction (A) of the superconducting magnet, for adaptation to multiple thicknesses of the axial support main body (21) in the axial direction (A) of the superconducting magnet.

6. The superconducting magnet as claimed in claim 1, wherein the connection unit (20) has an annular accommodating cavity (23) that extends in a circumferential direction (C) of the superconducting magnet, content material (40) in the accommodating cavity (23) being able to obtain cold from the refrigerator (30), and being able to output cold toward the superconducting coil (10) in a direction that is parallel to the axial direction (A) of the superconducting magnet.

7. The superconducting magnet as claimed in claim 6, wherein the content material (40) is a solid heat conducting filler or a flowing refrigerant, and, in a scenario in which the content material (40) is a solid heat conducting filler, the superconducting magnet further comprises copper braid (50), the refrigerator (30) transferring cold to the content material (40) by means of the copper braid (50), and, in a scenario in which the content material (40) is a flowing refrigerant, the superconducting magnet further comprises a connecting tube (60), one end of the connecting tube (60) communicating with the accommodating cavity (23), and the refrigerator (30) being connected to the other end of the connecting tube (60), to cool the flowing refrigerant that reaches the other end of the connecting tube (60).

8. The superconducting magnet as claimed in claim 6, wherein the connection unit (20) comprises an auxiliary heat conducting plate (26), the auxiliary heat conducting plate (26) being in the shape of a tube that extends along the axial direction (A) of the superconducting magnet and forming an outer peripheral cavity wall or an inner peripheral cavity wall of the accommodating cavity (23), and the auxiliary heat conducting plate (26) being attached to a circumferential face of the superconducting coil (10) in a thermally conductive manner, to transfer cold to the superconducting coil (10).

9. The superconducting magnet as claimed in claim 6, wherein the connection unit (20) is provided with a reinforcement structure (27) in the accommodating cavity (23), and the reinforcement structure (27) is supported in the axial direction (A) of the superconducting magnet between two side cavity walls of the accommodating cavity (23) in the axial direction (A) of the superconducting magnet.

10. The superconducting magnet as claimed in claim 1, wherein the superconducting coil (10) comprises:
a conductive wire (12), which is used for forming a main magnetic field for magnetic resonance imaging;
a connection block (13), which is arranged at an axial extremity of the superconducting coil (10) and is connected to the connection unit (20); and
an embedded body (14), the conductive wire (12) and the connection block (13) being fixed to the embedded body (14) in an embedding manner.

11. A magnetic resonance imaging device, comprising the superconducting magnet as claimed in any one of claims 1 to 10, the superconducting magnet being used for forming a main magnetic field for magnetic resonance imaging.
